# EUROPEAN PATENT SPECIFICATION

(11) **EP 0 441 638 B1**
(45) Date of publication and mention of the grant of the patent: **13.10.1999**
(21) Application number: 91301026.0
(22) Date of filing: 07.02.1991
(51) Int. Cl.: G03F 7/105, G03F 7/075

(54) **Light sensitive litho printing plate**
Lichtempfindliche lithographische Druckplatte
Plaque d'impression lithographique sensible à la lumière

(30) Priority: 08.02.1990 JP 2933390; 07.06.1990 JP 14742690
(43) Date of publication of application: 14.08.1991
(73) Proprietor: KONICA CORPORATION, Tokyo 163 (JP); Mitsubishi Chemical Corporation, Chiyoda-ku Tokyo (JP)
(72) Inventor: Suzuki, Norihito, Hino-shi, Tokyo (JP); Goto, Kiyoshi, Hino-shi, Tokyo (JP); Tomiyasu, Hiroshi, Tama-shi, Tokyo (JP); Noguchi, Kazuo, Hino-shi, Tokyo (JP); Kasakura, Akeo, Yokohama-shi, Kanagawa-ken (JP)
(74) Representative: Ellis-Jones, Patrick George Armine

(56) References cited:
- EP-A- 0 154 980
- EP-A- 0 316 705
- EP-A- 0 426 470
- PATENT ABSTRACTS OF JAPAN vol. 5, no. 173 (P-87)(845) 13 August 1981 & JP-A-56 101 141 ( KIMOTO KK )
- PATENT ABSTRACTS OF JAPAN vol. 5, no. 196 (P-93)(868) 12 December 1981 & JP-A-56 119 130 ( NIPPON KANKOUSHI KOGYO KK )

## Description

This invention relates to a method for preparing a printing plate, more particularly to method using a positive-working a light-sensitive litho printing plate which can give a printing plate requiring no dampening water with a sharp image after developing, and further will not contaminate hands or clothing after developing, etc.

A light-sensitive litho printing plate (hereinafter called "plate material" if necessary) requiring no dampening water, one having a light-sensitive layer and an ink repellent layer provided successively by coating on a support are known. By subjecting the plate material to exposure and developing, a litho printing plate (hereinafter called "printing plate" if necessary) can be obtained.

Such plate materials include those which dissolve the unexposed portion (image portion) of the light-sensitive material by use of a developer and remove the silicone rubber layer of the upper layer accompanied therewith as described in Japanese Patent Publication No. 22781/1980, and those which adhere the exposed portion (non-image portion) firmly to the light-sensitive layer by photoadhesion and remove only the silicone rubber layer at the unexposed portion (image portion) by swelling it with an organic solvent as disclosed in Japanese Unexamined Patent Publication No. 26923/1979.

Among them, those of the type which remove only the silicone rubber at the unexposed portion (image portion) by swelling it with an organic solvent involve the problem that, when the image is observed after developing, it can only be seen with difficulty, because only the silicone rubber layer is removed by developing.

This problem has been solved, for example in Japanese Unexamined Patent Publications Nos. 103103/1979, 133153/1988, etc., in which it is specifically disclosed to dye the light-sensitive layer or the primer layer exposed after developing with a dye, but these introduce problems on account of use of a dyeing solution such that the hands or clothing are contaminated with a dyeing solution remaining on the printing plate surface, or that the the automatic developing machine is contaminated with the dyeing solution.

Accordingly, the present inventors have carried out intensive studies in order to improve the above-mentioned problems, and consequently have found that not only can a printing plate with a sharp image be obtained, but also the hands or clothing will not be contaminated with a dyeing solution, nor will the automatic developing machine be contaminated, by incorporating a substance which forms color through the reaction with a component in the processing solution into the light-sensitive layer.

Therefore, an object of the present invention is to provide a light-sensitive litho printing plate requiring no dampening water which can give a sharp image after developing, and further will not contaminate hands or clothing, or contaminate an automatic developing machine with a dyeing solution after developing, etc.

The above-mentioned object of the present invention has been accomplished by a method for preparing a printing plate, which method comprises exposing a positive working light-sensitive litho printing plate comprising a support, a light-sensitive layer and a silicone rubber layer provided thereon,
wherein the light sensitive layer comprises at least one of a diazo resin or a diazo compound, developing the exposed printing plate to form a colour during developing or after developing.

In the present invention, the specific feature resides in incorporating a substance which forms a color simultaneously with developing or in the processing after developing into the light-sensitive layer of the positive working light-sensitive litho printing plate requiring no dampening water. More specifically, this embodiment includes the case when a diazo resin or diazo compound color forming substance is contained in the light-sensitive layer and a substance which forms a color through the reaction with the color forming substance, namely a coupler, is contained in the developer or a processing solution after developing, and the case when a color forming substance and a coupler are contained in the light-sensitive layer.

In the latter case, the color forming substance reacts with the coupler through the catalytic action of a substance in the processing solution to form a dye and effect color formation.

Preferably, the diazo resin or diazo compound color forming substance contained in the light-sensitive layer is a light-sensitive substance which undergoes photochemical reaction by exposure, whereby it will lose the ability to react with the component (coupler) in the processing solution or the light-sensitive layer and hence effect no color formation. In this case, the light-sensitive layer remaining on the non-image line portion has lost the ability to effect color formation, and therefore no color formation will occur even if the processing solution penetrates through the silicone rubber layer existing thereon.

Hence, the printing plate can show a particularly advantageous level of contrast between the image line portion and the non-image line portion.

By the above-mentioned processing solution is meant either a developer or a solution for processing the litho printing plate after developing. The substance which forms a color through the reaction with a coupler is a diazo resin, or a salt or a diazo compound, such as a hydrochloride, a tetrafluoroboric acid salt, a hexafluorophosphoric acid salt, a zinc chloride complex, etc., as exemplified by the specific compounds shown below: 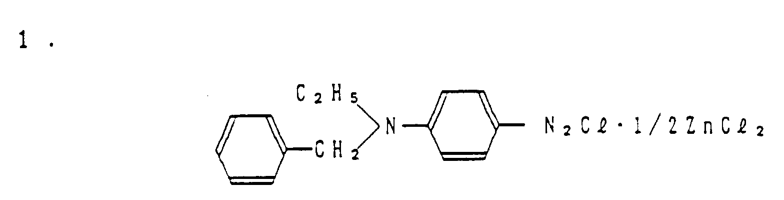 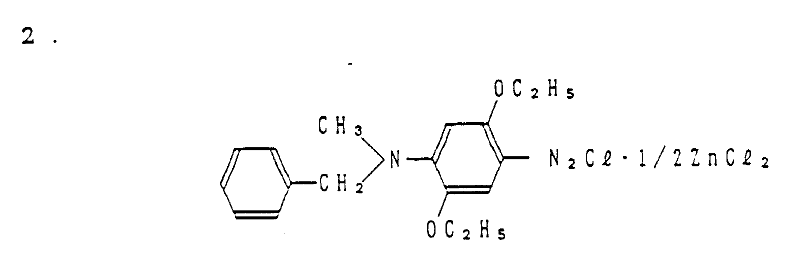 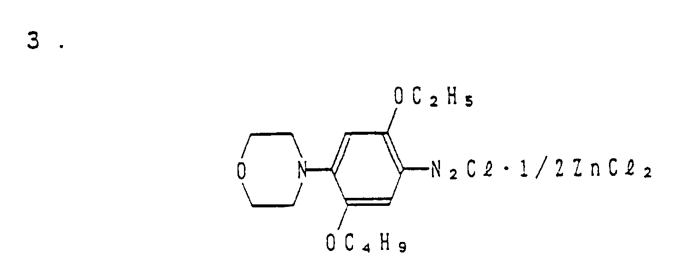 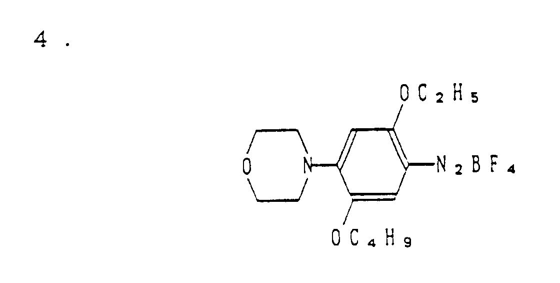 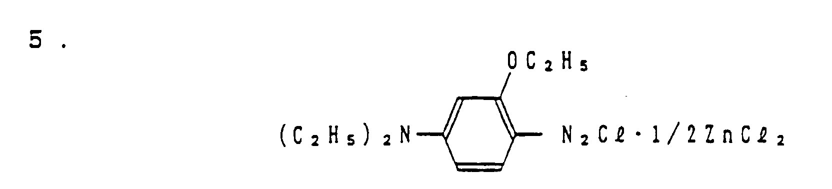 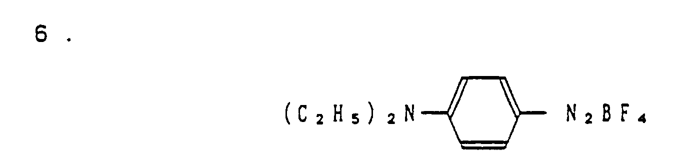 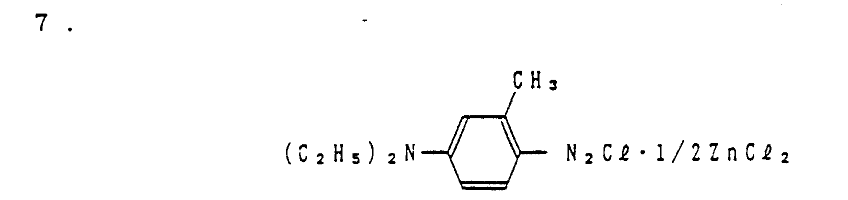 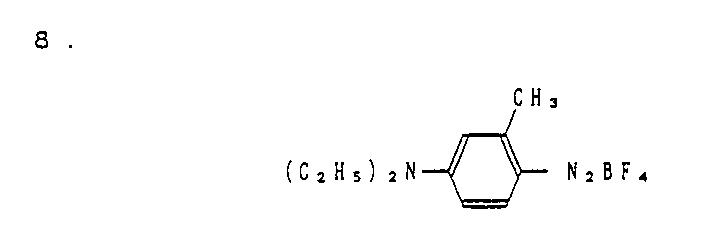 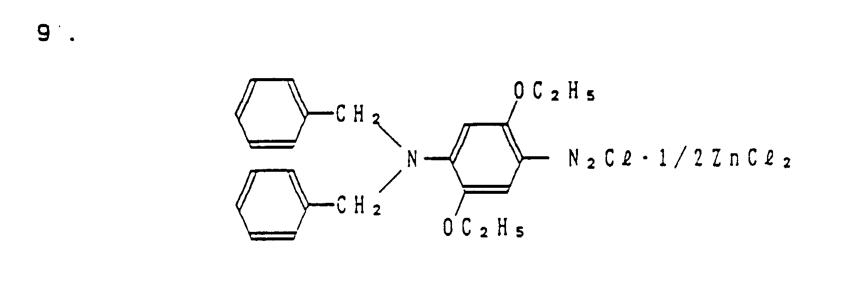 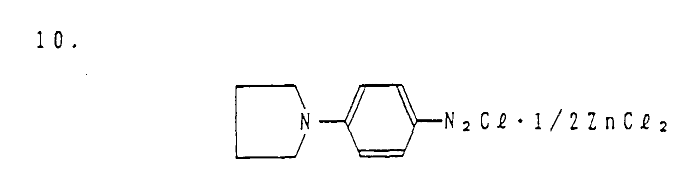 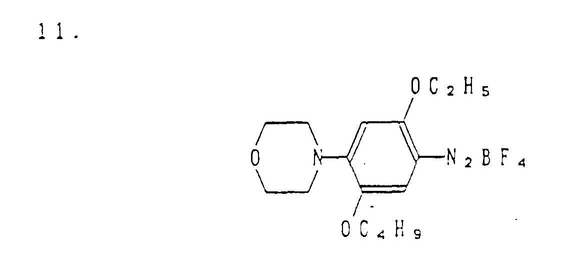 The content of the diazo resin may be from 10% by weight to 90% by weight, preferably from 30% by weight to 70% by weight, in the solids of the light-sensitive composition.

The content of the diazo compound may be from 5 to 45% by weight, preferably from 10 to 30% by weight.

In the above-mentioned processing solution and/or the light-sensitive layer, a substance is included which forms a dye through reaction with the diazonium salt color forming substance existing in the light-sensitive layer, namely a coupler, and the coupler may include acylacetanilides, 1,3-substituted pyrazolones, phenols, naphthols, etc.

Specific compounds may include, for example, β-naphthol, 1-phenyl-3-methyl-5-pyrazolone, 1,5-dihydroxynaphthalene, or otherwise the couplers shown below.

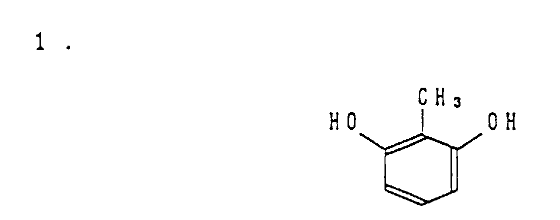

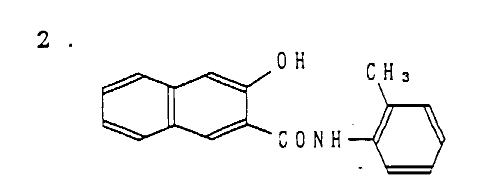

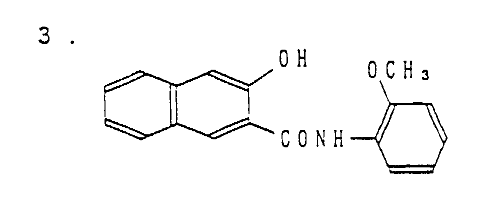

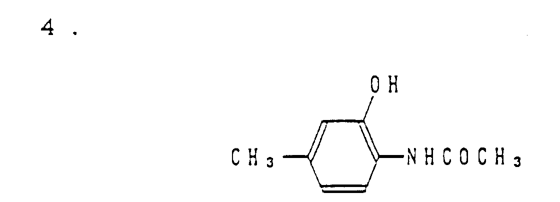

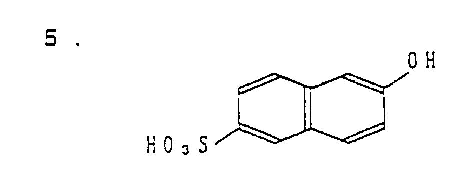

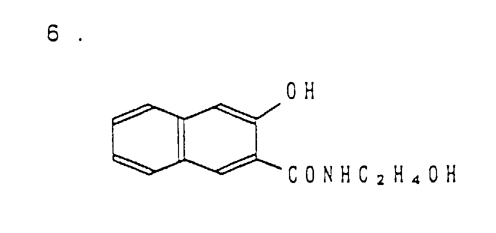

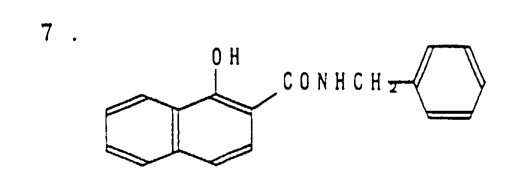

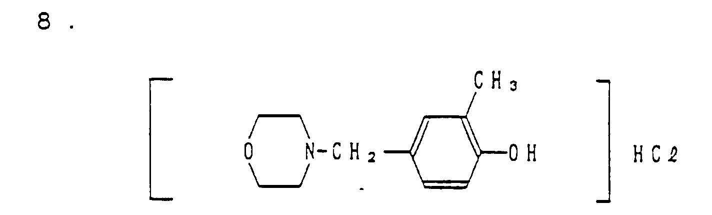

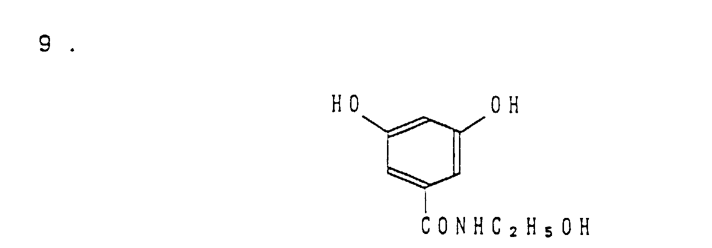

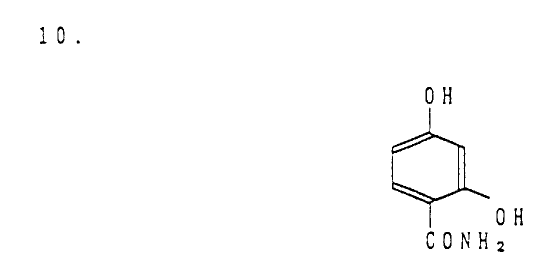

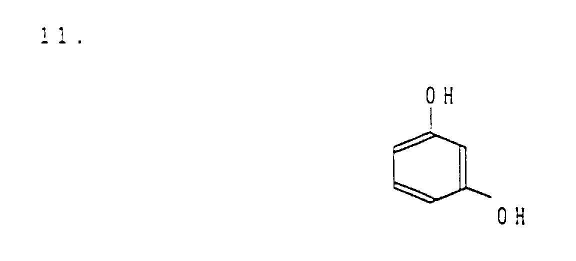

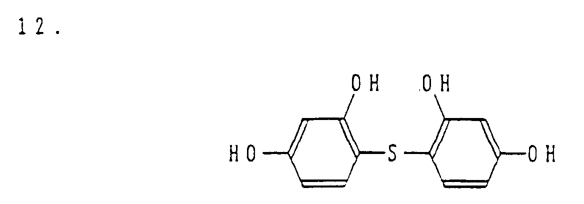

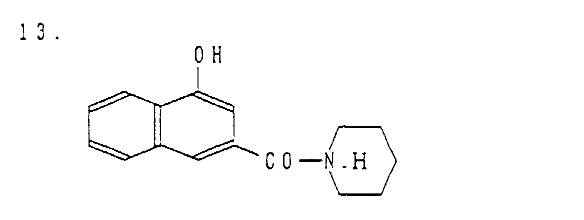

The content of the coupler, when incorporated in the processing solution, may be from 0.1 % by weight to 20 % by weight, preferably from 1 % by weight to 10 % by weight, based on the processing solution.

When a coupler is incorporated in the light-sensitive layer, it may be contained in an amount of from 0.2 % by weight to 40 % by weight, preferably from 1 % by weight to 30 % by weight, in the solids of the light-sensitive composition.

In the present invention, after exposure of the light-sensitive litho printing plate requiring no dampening water having a diazo resin or diazo compound which forms a color simultaneously with developing or processing after developing incorporated in the above-described light-sensitive layer, by effecting color formation simultaneously with developing or processing with a processing solution when processed with the processing solution after developing, a printing plate excellent in layout proof can be obtained.

When the processing solution contains a coupler, it may contain, in addition to the above-described coupler, an organic solvent which dissolves the coupler, water, a surfactant, or an alkali agent which has the catalytic action for the reaction between the color forming substance and the coupler.

When the light-sensitive layer contains a coupler, it may contain an organic solvent, water, a surfactant, an alkali agent, etc. In this case, because no coupler is required to be dispersed or dissolved in the processing solution, the amounts of the organic solvent and the surfactant used can be decreased and advantageous effects can be obtained in aspects of the working environment and in waste solution disposal of the processing solution.

The processing solution containing a substance reactive with the diazo resin or diazo compound color forming substance existing in tne light-sensitive layer or a coupler or having the catalytic action for reaction with the color forming substance in the light-sensitive layer may be either the same as or different from the developer, but should be preferably the same as the developer, because it is more preferable that color formation can be effected simultaneously with developing.

As the silicone rubber layer optionally used in the method of the present invention, one composed mainly of a linear organic polysiloxane having hydroxyl groups in the main chain having the repeating units shown by the following formula [I] and a molecular weight of some 1000 to some 100,000 or at the ends of the main chain is preferred. 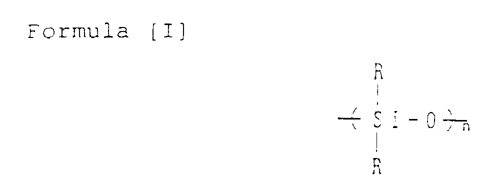 Here, n is 2 or more, R is an alkyl group having 1 to 10 carbon atoms, a halogenated alkyl group, an alkoxyl group, a vinyl group, an aryl group or a silanol group (OH group), with 60 % or more of R being preferably methyl groups. The above-mentioned silanol group (OH group) may be either in the main chain or at the ends of the main chain, but preferably at the ends of the main chain.

The silane coupling agent (or silicone crosslinking agent) suitable for use in the method of the present invention may be a silane compound represented by the formula:

RₙSiX₄₋ₙ

(wherein n is an integer of 1 to 3, R represents a monovalent group such as alkyl, aryl, alkenyl or a combination of these, and these groups may also have functional groups such as halogen, amine, hydroxy, alkoxy, aryloxy, thiol, etc. X represents a substituent such as -OH, -OR², -OAc, 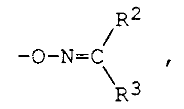 -Cl, -Br, -I, etc. Here, R² and R³ represent the same as the above R, and may be either the same or different. Ac represents acetyl group).

Useful silicone rubber compounds for use in the method of the present invention are those obtained by a condensation reaction between such silicone base polymers and the silicone crosslinking agent as described above.

Specific examples of the silane coupling agent suitable for use in the method of the present invention may include HN[(CH₂)₃Si(OMe)₃]₂, vinyltriethoxysilane, Cl(CH₂)₃Si(OMe)₃, CH₃Si(OAc)₃, HS(CH₂)₃Si(OMe)₃, vinyltris(methyl ethyl ketoxime)silane, etc.

The above-mentioned silicone rubber compound is also available as a commercial product, including, for example, YE-3085 manufactured by Toshiba Silicone. Other useful silicone rubber compounds can be also obtained by reaction of the base polymer as described above with a silicone oil having repeating units represented by the following formula [IIj, or by an addition reaction with a base polymer of silicone of which about 3 % of R are vinyl groups, or a reaction mutually between said silicone oils. 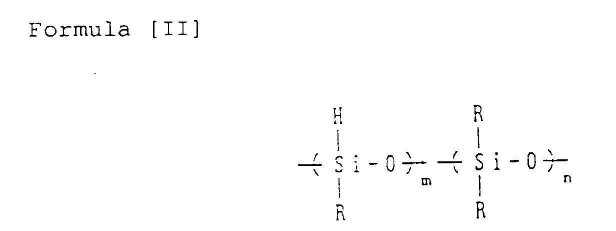 (wherein R is as defined for R in formula [I] above, m is 2 or more, and n is integer 0 or 1 or more).

For obtaining the silicone rubber compound by such a crosslinking reaction, the crosslinking reaction is carried out by use of a catalyst. As such catalyst, there may be employed organic carboxylic acid salts of metals such as tin, zinc, cobalt, lead, calcium, manganese, etc., as exemplified by dibutyltin laurate, tin (II) octoate, cobalt naphthenate, etc. or chloroplatinic acid, etc.

For the purpose of obtaining a silicone rubber compound which can stand the frictional force occurring during the printing operation by improving the strength of the silicone rubber, a a filler can be also mixed therein. Silicone rubbers previously mixed with fillers are commercially available as silicone rubber stocks or silicone rubber dispersions, and when it is desirable to obtain a silicone rubber film by coating as in the present invention, a dispersion of RTV or LTV silicone rubber may be preferably employed. Examples of such dispersions may include silicone rubber dispersions for paper coating such as Syl Off 23, SRX-257, SH237, etc.

In the method of the present invention, it is preferable to employ a silicone rubber of the condensation crosslinked type.

In the silicone rubber layer, for further improvement of adhesion, a silane coupling agent having amino groups may be preferably contained.

Examples of preferable silane coupling agents may include the following:
(a) H₂NCH₂CH₂NH(CH₂)₃Si(OCH₃)₃
(b) H₂NCE₂CH₂NH(CH₂)₃Si(OCH₃)₂(CH₃)
(c) H₂N(CH₂)₃Si(OEt)⁻₃

In the silicone rubber layer to be used in the method of the present invention, a small amount of a photosensitizer may be added.

The silicone rubber layer used in the method of the present invention can be prepared by dissolving a silicone rubber in an appropriate solvent, then coating on the light-sensitive layer and drying.

As the light-sensitive composition to be used in the method of the present invention, any known light-sensitive composition can be used, but preferably a diazo resin and a photopolymerizable compound may be used, particularly preferably a diazo resin which can function also as the substance which forms a color through the reaction with the component (coupler) in the processing solution and/or the light-sensitive layer.

In the following, the light-sensitive composition is described in detail.

(1) Light-sensitive composition containing a diazo resin: The diazo resin suitable for use in the method of the present invention includes various resins, but preferably, a diazo resin as represented by the condensation between p-diazodiphenylamine and formaldehyde, which resin is insoluble in water and soluble in an organic solvent, preferably one insoluble in water and soluble in conventional organic solvents as described in Japanese Patent Publications Nos. 1167/1972 and 43890/1982. Particularly preferably, a diazo resin represented by the following formula [III] may be employed. 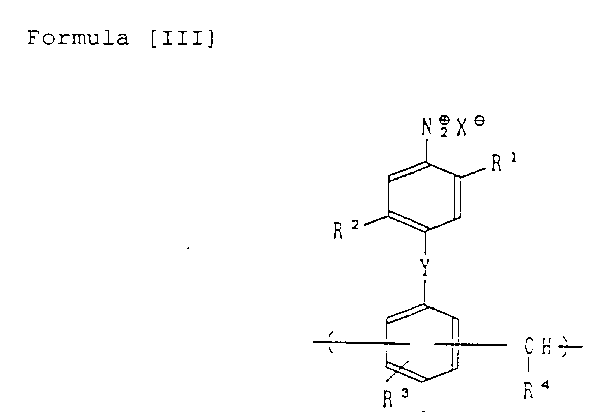 [wherein R¹, R² and R³ represent a hydrogen atom, an alkyl group or an alkoxy group, R⁴ represents a hydrogen atom, an alkyl group or a phenyl group, X represents an anion, and Y represents -NH-, -S- or -O-].

As the diazo monomer in the diazo resin which may be used in the method of the present invention, diazo compounds as mentioned above can be used, and preferable examples may include 4-diazodiphenylamine, 3-methoxy-4-diazodiphenylamine, 3-ethoxy-4-diazodiphenylamine.

As the aldehyde which may be used as the condensing agent with the above-mentioned diazo monomer, for example, there may be included formaldehyde, acetaldehyde, propionaldehyde, butylaldehyde, isobutylaldehyde, or benzaldehyde, etc.

Further, as the anion, a water-soluble diazo resin can be obtained by use of chloride ions or tetrachlorozinc acid, etc., or alternatively a diazo resin soluble in an organic solvent can be obtained by use of boron tetrafluoride, hexafluorophosphoric acid, triisopropylnaphthalenesulfonic acid, 4,4'-biphenyldisulfonic acid, 2,5-dimethylbenzenesulfonic acid, 2-nitrobenzenesulfonic acid, 2-methoxy-4-hydroxy-5-benzoyl-benzenesulfonic acid, etc. Particularly preferably, a diazo resin comprising hexafluorophosphoric acid may be employed.

The diazo resin should preferably be used as a mixture with a film forming resin (binder), particularly a lipophilic polymeric compound having hydroxyl groups. As such lipophilic polymeric compound, there may be included monomers having aliphatic hydroxyl groups in the side chain, such as 2-hydroxyethyl acrylate or a copolymer of 2-hydroxyethyl methacrylate and other monomers copolymerizable therewith. Other than these, if necessary, polyvinylbutyral resin, polyurethane resin, polyamide resin, epoxy resin, novolac resin, other natural resins, etc. may be also added.

Otherwise, as the binder to be used in combination with the diazonium salt, various polymeric compounds can be used, preferably copolymers of monomers having aromatic hdyroxyl groups such as N-(4-hydroxyphenyl)acrylamide, N-(4-hydroxyphenyl)methacrylamide, o-, m- or p-hydroxystyrene, o-, m- or p-hydroxyphenyl methacrylate as described in Japanese Unexamined Patent Publication No. 98613/1979; polymers containing hydroxyethyl acrylate units or hydroxyethyl methacrylate units as the main repeating units as described in U.S. Patent 4,123,276; natural resins such as shellac, rosin, etc.; polyvinyl alcohol; polyamide resins as described in U.S. Patent 3,751,757; ; linear polyurethane resins, phthalated resins of polyvinyl alcohol, epoxy resins condensed from bisphenol A and epichlorohydrin, as described in U.S. Patent 3,660,097; and as alkali-soluble resins, novolac resins, vinyl type polymers having phenolic hydroxyl groups, condensed resins of polyvalent phenol and aldehyde or ketone as described in Japanese Unexamined Patent Publication No. 57841/1980; and so on. Examples of novolac resins may include phenolformaldehyde resins, cresol-formaldehyde resin, phenol-cresol-formaldehyde copolycondensed resins, copolycondensed resins of p-substituted phenol with phenol, or cresol and formaldehyde.

These binders may be contained in amounts of from 10 to 95 % by weight, preferably from 40 to 80 % by weight, in the solids of the light-sensitive composition. On the other hand, the diazo resin may be contained in an amount of from 5 to 80 % by weight, preferably from 15 to 60 % by weight.

The amounts of additives to be added optionally in the above-mentioned light-sensitive composition such as ink receptive agents, surfactants, sensitizers, stabilizers, thermal polymerization inhibitors, plasticizers, dyes, pigments, etc. depend on the kinds of additives, but may be generally from 0.01 to 20 % by weight, preferably from 0.05 to 10 % by weight, based on the light-sensitive composition contained in the light-sensitive coating solution.

The support suitable for use as the plate material in the method of the present invention should be preferably one which can provide bending characteristics suitable for use in a conventional litho printing machine taking into account the load applied during printing. For example, there may be included metal plates such as those made of aluminum, zinc, copper, steel, etc., and metal plates having chromium, zinc, copper, nickel, aluminum and iron, etc. plated or vapor deposited thereon, paper, plastic films and glass plates, resin coated paper, paper having metal foil such as of aluminum, etc. laminated thereon.

An aluminum plate is preferred.

The treatment on the support itself for improvement of adhesion as mentioned above is not particularly limited, but various surface roughening treatments may be included.

Before coating the support with the light-sensitive layer, for obtaining sufficient adhesion between the light-sensitive layer and the support, a primer layer may be also provided on the support, and said primer layer may include, for example, polyester resin, vinyl chloride-vinyl acetate copolymer, acrylic resin, vinyl chloride resin, polyamide resin, polyvinyl butyral resin, epoxy resin, acrylate type copolymer, vinyl acetate type copolymer, phenoxy resin, polyurethane resin, polycarbonate resin, polyacrylonitrile butadiene, polyvinyl acetate, etc.

As the anchor agent constituting the above-mentioned primer layer, for example, silane coupling agents, organic titanates, etc. are also effective.

The thicknesses of the respective layers constituting the plate material for use in the present invention are as described below. That is, the support has a thickness of from 50 to 1000 µm, preferably from 100 to 300 µm, the light-sensitive layer from 0.05 to 10 µm, preferably from 0.5 to 5.0 µm, and the silicone rubber layer from 0.5 to 100 µm, preferably from 1 to 4 µm.

The silicone rubber layer may also have a protective layer on its upper surface, if desired.

The plate material requiring no dampening water may be prepared, for example, as described below.

On a support, a composition solution to constitute the light-sensitive layer is coated and dried by use of a conventional coater such as reverse roll coater, air knife coater, Meyer bar coater, etc, or a rotary coating device such as a wheeler.

If necessary, a primer layer can be provided between the support and the light-sensitive layer in the same manner as in provision of said light-sensitive layer and cured by heating or exposure, followed by coating and drying of the light-sensitive layer, and further a silicone rubber solution can be coated according to the same method on the light-sensitive layer and heated generally at a temperature of from 100 to 120 °C for several minutes to be sufficiently cured, thereby forming a silicone rubber layer. If necessary, a protective film can be formed on said silicone rubber layer by means of a laminator.

Next, the method for preparing the printing plate requiring no dampening water using the plate material requiring no dampening water in accordance with the present invention is described.

A positive film which is an original manuscript is vacuum adhered on the surface of a posi-type plate material and subjected to exposure. As the light source for this exposure, there may be employed a mercury lamp, carbon arc lamp, xenon lamp, metal halide lamp, fluorescent lamp, etc. which abundantly generate UV-rays.

Next, the positive film is peeled off and developed with a developer. As the developer, those known in the art as developers for the plate material and requiring no dampening water can be utilized, preferably an aqueous developer.

The aqueous developer can include developers containing 30 % by weight or more, preferably from 50 % by weight to 98 % by weight, of water and an organic solvent, a surfactant, and further preferably containing an alkali agent.

More preferably, a substance reactive with the above-mentioned color forming substance or the above-mentioned coupler is contained so that the color forming substance existing in the light-sensitive layer can form a color simultaneously with developing.

As the organic solvent contained in the developer comprising water as the main component, there may be included, for example, aliphatic hydrocarbons (hexane, heptane, "Isopar E, H, G" (Esso Chemical, trade names of aliphatic hydrocarbons) or gasoline, kerosene, etc.), aromatic hydrocarbons (toluene, xylene, etc.), or halogenated hydrocarbons (Triclene, etc.), alcohols (methanol, ethanol, 1-butoxy-2-propanol, 3-methyl-3-methoxybutanol, benzyl alcohol, etc.), ethers (methyl cellosolve, ethyl cellosolve, butyl cellosolve, phenyl cellosolve, methyl carbitol, ethyl carbitol, butyl carbitol, dioxane, diethylene glycol dimethyl ether, diethylene glycol diethyl ether, diethylene glycol dibutyl ether, ethylene glycol dibutyl ether, propylene glycol, dipropylene glycol butyl ether, tripropylene glycol methyl ether, polypropylene glycol methyl ether, etc.), ketones (acetone, methyl ethyl ketone, methyl isobutyl ketone, diisobutyl ketone, 4-methyl-1,3-dioxorane-2-one, etc.), esters (ethyl acetate, propyl acetate, hexyl acetate, methyl butyrate, propyl butyrate, diethyl succinate, dibutyl oxalate, diethyl maleate, benzyl benzoate, methyl cellosolve acetate, cellosolve acetate, carbitol acetate, etc.), and so on.

As the surfactant to be added in the developer for use with the present invention, there may be included anionic surfactants, nonionic surfactants, cationic surfactants and amphoteric surfactants, specifically those as set forth below:
(1) Higher alcohol sulfates (e.g. sodium salt of lauryl alcohol sulfate, ammonium salt of octylalcohol sulfate, ammonium salt of lauryl alcohol sulfate, secondary sodium alkyl sulfate, etc.);
(2) Aliphatic alcohol phosphate salts (e.g. sodium salt of cetyl alcohol phosphate, etc.);
(3) Alkylaryl sulfonic acid salts (e.g. sodium dodecylbenzenesulfonate, sodium isopropylnaphthalenesulfonate, sodium dinaphthalenesulfonate, sodium metadinitrobenzenesulfonate, etc.);
(4) Alkylamidesulfonic acid salts: eg. 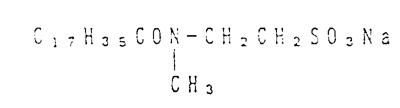
(5) Sulfonic acid salts of dibasic fatty esters (e.g. sodium dioctyl sulfosuccinate, sodium dihexyl sulfosuccinate, etc.);
(6) formaldehyde condensate of alkylnaphthalenesulfonic acid salts (e.g. formaldehyde condensate of sodium dibutylnaphthalenesulfonate).

As the nonionic surfactant, there may be included polyoxyethylene alkyl ethers, polyoxyethylene alkyl phenol ethers, polyethylene fatty acid esters, sorbitane fatty acid esters, polyoxyethylene sorbitane fatty acid esters, glycerine fatty acid esters, oxyethylene oxypropylene block polymers, etc.

As the cationic surfactant, alkylamine salts, quaternary ammonium salts, polyoxyethylene alkylamines, etc. may be included.

As the amphoteric surfactant, alkyl betaines may be included, and among these, anionic surfactants are suitable.

These surfactants can be used either singly or as a combination of two or more kinds.

The amount of the surfactant to be used with the present invention may be suitably from 0.01 % by weight to 60 % by weight, preferably from 0.1 % by weight to 10 % by weight.

Further, as the alkali agent to be used with the present invention, there may be included:
(1) inorganic alkali agents such as sodium silicate, potassium silicate, potassium hydroxide, sodium hydroxide, lithium hydroxide, secondary or tertiary sodium or ammonium phosphate, sodium metasilicate, sodium carbonate, ammonia, etc.;
(2) organic amine compounds such as mono-, di- or trimethylamine, mono-, di- or triethylamine, , mono- or diisopropylamine, n-butylamine, mono-, di- or triethanolamine, mono-, di- or triisopropanolamine, ethylenimine, ethylenediimine, etc.

The alkali agent may be used in an amount of from 0.05% by weight to 20 % by weight, preferably from 0.2 % by weight to 10 % by weight.

Developing can be carried out by rubbing with a pad containing the developer as described above or by pouring the developer onto the plate surface followed by rubbing with a brush, etc.

By developing as described above, a printing plate may be obtained in which a part of the light-sensitive layer at the unexposed portion and the silicone rubber are removed, or the light-sensitive layer color formed by removal only of the silicone rubber layer is exposed. A printing plate having the silicone rubber layer and the light-sensitive layer substantially without color formation in the exposed portion is thus obtained.

### Example - 1

### Synthesis of diazo resin - 1:

An amount 14.5 g (50 mmole) of p-diazodiphenylamine sulfate was dissolved under ice-cooling in 40.9 g of conc. sulfuric acid. Into the solution was added slowly 1.35 g (45 mmole) of p-formaldehyde so that the reaction temperature did not exceed 10 °C.

The reaction mixture under ice-cooling was added dropwise into 500 ml of ethanol, and the precipitates formed were filtered. After washing with ethanol, the precipitates were dissolved in 100 ml of pure water, and into the solution was added a cold conc. aqueous solution containing 6.8 g of zinc chloride dissolved therein.

The precipitates formed were filtered, then washed with ethanol and this was dissolved in 150 ml of pure water. Into the solution was added cold conc. aqueous solution containing 8 g of ammonium hexafluorophosphate dissolved therein. The precipitates formed were collected by filtration, washed with water and dried to obtain a diazo resin - 1.

### Preparation of aluminum plate a:

An aluminum plate with a thickness of 0.24 mm was defatted by dipping in an aqueous 3 % sodium hydroxide, washed with water and subjected to anodic oxidation in an aqueous 32 % sulfuric acid under the conditions of a temperature of 30 °C, at 5 A/dm² for 10 seconds. The plate was then washed with water, dipped in an aqueous 2 % sodium metasilicate at a temperature of 85 °C for 37 seconds, further in water (pH 8.5) of 90 °C for 25 seconds, washed with water and dried to give an aluminum plate a.

The aluminum plate a was coated with a primer layer composition having the following composition, dried at 85 °C for 3 minutes and subjected to whole surface exposure of 1000 mJ/cm² by use of a 3 KW ultra-high pressure mercury lamp. Further, the coating was dried at 100 °C for 4 minutes and dried to form a primer layer with a thickness of 3.0 µm.

### Primer layer composition:

| | | |
|---|---|---|
| (1) | Diazo resin - 1 | 8 parts |
| (2) | Copolymer resin - 1 of 2-hydroxyethyl methacrylate, methyl methacrylate with a molar ratio of 34/64 | 92 parts |
| (3) | FINEX - 25 (zinc oxide pigment, manufactured by Sakai Kagaku K.K.) | 30 parts |
| (4) | Methyl cellosolve | 870 parts |

Next, on the above-mentioned primer layer was coated a light-sensitive composition having the following composition, followed by drying at 100 °C for 2 minutes, to form a light-sensitive layer with a thickness of 1.2 µm.

### (Light-sensitive composition):

| | | |
|---|---|---|
| (1) | Diazo resin - 1 | 50 parts |
| (2) | Copolymer resin - 1 of 2-hydroxyethyl | |
| | methacrylate, N-(4-hydroxyphenyl)methacrylamide, methyl methacrylate, acrylonitrile with a molar ratio of 20/10/50/20 | 50 parts |
| (3) | Victoria Pure Blue BOH (dye, manufactured by Hodogaya Kagaku K.K.) | 1 part |
| (5) | Methyl lactate | 1900 parts |

Next, on the above-mentioned light-sensitive layer was coated the following silicone rubber composition to a dry weight of 1.8 g/m², followed by drying at 90 °C for 10 minutes.

### (Silicone rubber layer composition):

| | | |
|---|---|---|
| (1) | Dimethylpolysiloxane having hydroxyl groups at the both ends (molecular weight:82,000) | 100 parts |
| (2) | Triacetoxymethylsilane | 5 parts |
| (3) | 1,3,5-Tris(trimethoxysilylpropyl) isocyanurate | 2.5 parts |
| (4) | Dibutyltin laurate | 0.8 part |
| (5) | Isopar E (manufactured by Esso Chemical) | 900 parts |

Next, on the above-mentioned silicone rubber layer was laminated a polypropylene film with a thickness of 5 µ to obtain a water-free litho plate.

After a positive film was vacuum adhered onto the upper surface of the above-described plate material, exposure was effected by use of a metal halide lamp as the light source. Next, after dipping in the following developer - 1 for one minute, the silicone rubber layer at the unexposed portion was removed, by rubbing the surface of the plate material with a pad impregnated with a developer. The dots were well reproduced to give a printing plate with a light-sensitive layer in which the image line portion was color formed in blue at the unexposed portion.

### (Developer - 1):

| | |
|---|---|
| Benzyl alcohol | 2 parts |
| Pellex NBL (35 % aqueous anionic surfactant | |
| solution, manufactured by Kao-Atlas) | 6 parts |
| Diethanolamine | 2 parts |
| 2-Hydroxy-N-(2-methylphenyl)-3-naphthoamide | 3 parts |
| Propylene glycol | 20 parts |
| Water | 67 parts |

### Example 2

A litho printing plate material requiring no dampening water was obtained in the same manner as in Example - 1 except for changing the light-sensitive composition, the silicone rubber layer composition and the developer in Example - 1 as follows.

### (Photosensitive composition - 2):

| | | |
|---|---|---|
| (1) | Diazo resin- 1 | 15 parts |
| (2) | Copolymer resin - 2 of 2-hydroxyethyl methacrylate, N-(4-hydroxyphenyl)methacrylamide, methyl methacrylate, acrylonitrile, allyl methacrylate with a molar ratio of 20/10/50/10/10 | 50 parts |
| (3) | Pentaerythritol triacrylate | 15 parts |
| (4) | Tetramethylomethane tetraacrylate | 20 parts |
| (5) | Victoria Pure Blue BOH (dye, manufactured by Hodogaya Kagaku K.K.) | 1 part |
| (6) | Kayacure DETX (2,4-Diethylthioxanthon photopolymerization initiator, manufactured by Nippon Kayaku K.K.) | 5 parts |
| (7) | Kayacure EPA (p-Dimethylamino benzoic acid ethyl ester photopolymerization promotor, manufactured by Nippon Kayaku K.K.) | 2 parts |
| (8) | Methyl lactate | 1900 parts |

### (Silicone rubber layer composition):

| | |
|---|---|
| Dimethylpolysiloxane having hydroxyl groups at the both ends (molecular weight 82,000) | 100 parts |
| Triacetoxyvinylsilane | 5 parts |
| 1-Trimethoxysilylpropyl-3,5-diallyl isocyanurate | 2.5 parts |
| Dibutyltin laurate | 0.8 part |
| Isopar E (manufactured by Esso Chemical) | 900 parts |

### (Developer - 2):

| | |
|---|---|
| Benzyl alcohol | 2 parts |
| Pellex NBL (aqueous 35 % anionic surfactant, manufactured by Kao-Atlas) | 17 parts |
| Diethanolamine | 2 parts |
| 2-Hydroxy-N-(2-methylphenyl)-3-naphthoamide | 3 parts |
| Tripropylene glycol monomethyl ether | 45 parts |
| Isopar H (isoparaffinic solvent, manufactured by Esso Chemical K.K.) | 6 parts |
| Water | 25 parts |

Similarly as in Example - 1, the dots were well reproduced to give a printing plate with a light-sensitive layer in which the image line portion was color formed in blue at the unexposed portion.

### Example - 3

A litho printing plate material requiring no dampening water was obtained in the same manner as in Example - 1 except for changing the light-sensitive composition in Example - 2 as follows.

### (Light-sensitive composition - 3):

| | | |
|---|---|---|
| (1) | 2,5-Diethoxy-4-morpholinobenzenediazonium- | |
| | fluoroborate | 15 parts |
| (2) | Copolymer resin - 2 of 2-hydroxyethyl methacrylate, N-(4-hydroxyphenyl)methacrylamide, methyl methacrylate, acrylonitrile, allyl methacrylate with a molar ratio of 20/10/50/10/10 | 50 parts |
| (3) | Pentaerythritol triacrylate | 15 parts |
| (4) | Tetramethylolmethane tetraacrylate | 20 parts |
| (5) | Victoria Pure Blue BOH (dye, manufactured by Hodogaya Kagaku K.K.) | 1 part |
| (6) | Kayacure DETX (2,4-Diethylthioxanthone photopolymerization initiator,manufactured by Nippon Kayaku K.K.) | 5 parts |
| (7) | Kayacure EPA (p-Dimethylamino benzoic acid ethyl ester photopolymerization promotor, manufactured by Nippon Kayaku K.K.) | 2 parts |
| (8) | Methyl lactate | 1900 parts |

The dots were well reproduced similarly to those in Example - 1, to give a printing plate with a light-sensitive layer in which the image line portion was color formed in blue at the unexposed portion.

### Comparative example - 1

A litho printing plate material requiring no dampening water was obtained in the same manner as in Example - 3 except for changing 15 parts of (1) 2,5-diethoxy-4-morpholino-benzenediazoniumfluoroborate to 15 parts of the Copolymer resin - 2.

A printing plate with well reproduced dots similar to those in Example - 1 was obtained, but no color formation of the image line portion occurred, with the image after developing being indistinct, and dyeing of the image line portion with a dye solution was necessary.

### Example - 4

A litho printing plate requiring no dampening water was obtained in the same manner as in Example - 1 except for changing the developer in Example - 1 as follows.

### (Developing solution - 3):

| | |
|---|---|
| Benzyl alcohol | 2 parts |
| Pellex NBL (35 % aqueous anionic surfactant, manufactured by Kao-Atlas) | 6 parts |
| Diethanolamine | 2 parts |
| N-(2-hydroxyethyl)-3,5-dihydroxybenzamide | 3 parts |
| Propylene glycol | 20 parts |
| Water | 67 parts |

The dots were well reproduced to give a printing plate in which the image line portion was color formed in red at the unexposed portion.

### Example - 5

The aluminum plate as prepared in Example 1 was coated with a primer layer composition having the following composition, dried at 85 °C for 3 minutes, and then subjected to whole surface exposure of 1000 mJ/cm² by use of a 3 KW ultra-high pressure mercury lamp. Further, the coating was dried at 100 °C for 4 minutes to form a primer layer with a thickness of 3.0 µm.

### Primer layer composition:

| | | |
|---|---|---|
| (1) | Diazo resin - 1 | 8 parts |
| (2) | Copolymer resin - 1 of 2-hydroxyethyl methacrylate and methyl methacrylate with a molar ratio of 34/64 | 92 parts |
| (3) | FINEX - 25 (zinc oxide pigment, manufactured by Sakai Kagaku K.K.) | 30 parts |
| (4) | Methyl cellosolve | 870 parts |

Next, on the above-mentioned primer layer was coated a light-sensitive composition having the following composition, followed by drying at 100 °C for 2 minutes, to form a light-sensitive layer with a thickness of 1.2 µm.

### (Light-sensitive composition):

| | | |
|---|---|---|
| (1) | Diazo resin - 1 | 50 parts |
| (2) | Copolymer resin - 1 of 2-hydroxyethyl methacrylate, N-(4-hydroxyphenyl)methacrylamide, methyl methacrylate, acrylonitrile with a molar ratio of 20/10/50/20 | 50 parts |
| (3) | Victoria Pure Blue BOH (dye, manufactured by Hodogaya Kagaku K.K.) | 1 part |
| (4) | 2-Hydroxy-N-(2-methylphenyl)-3-naphtoamide | 15 parts |
| (5) | Methyl lactate | 1900 parts |

Next, on the above-mentioned light-sensitive layer was coated the following silicone rubber composition to a dry weight of 1.8 g/m², followed by drying at 90 °C for 10 minutes.

### (Silicone rubber layer composition):

| | | |
|---|---|---|
| (1) | Dimethylpolysiloxane having hydroxyl groups at both ends (molecular weight 82,000) | 100 parts |
| (2) | Triacetoxymethylsilane | 5 parts |
| (3) | 1,3,5-Tris(trimethoxysilylpropyl) isocyanurate | 2.5 parts |
| (4) | Dibutyltin laurate | 0.8 part |
| (5) | Isopar E (manufactured by Esso Chemical) | 900 parts |

Next, on the above-mentioned silicone rubber layer was lamianted a polypropylene film with a thickness of 5 µ to give a litho printing plate requiring no dampening water.

After a positive film was vacuum adhered onto the upper surface of the above-mentioned plate material, exposure was effected by use of a metal halide lamp as the light source. Next, the plate material was dipped in the following developer - 4, and then the surface of the plate material was rubbed with a pad impregnated with the developer to remove the silicone rubber layer at the unexposed portion, whereby the dots were well reproduced to obtain a printing plate with a light-sensitive layer in which the image line portion was color formed in blue at the unexposed portion

### (Developer - 4):

| | |
|---|---|
| Benzyl alcohol | 2 parts |
| Pellex NBL (35 % aqueous anionic surfactant, manufactured by Kao-Atlas) | 6 parts |
| Diethanolamine | 2 parts |
| Propylene glycol | 20 parts |
| Water | 67 parts |

### Example 6

A printing plate material requiring no dampening water was obtained in the same manner as in Example - 1 except for changing the light-sensitive composition, the silicone rubber layer composition, and the developer as follows.

### (Light-sensitive composition - 2)

| | | |
|---|---|---|
| (1) | Diazo resin - 1 | 15 parts |
| (2) | Copolymer resin - 2 of 2-hydroxyethyl methacrylate, -(4-hydroxyphenyl)methacrylamide, methyl methacrylate, acrylonitrile, allyl methacrylate with a molar ratio of 20/10/50/10/10 | 50 parts |
| (3) | Pentaerythritol triacrylate | 15 parts |
| (4) | Tetramethylolmethane tetraacrylate | 20 parts |
| (5) | Victoria Pure Blue BOH (dye, manufactured by Hodogaya Kagaku K.K.) | 1 part |
| (6) | Kayacure DETX (2,4-Diethylthioxanthone photopolymerization initiator, manufactured by Nippon Kayaku K.K.) | 5 parts |
| (7) | Kayacure EPA (p-Dimethylamino benzoic acid ethyl ester photopolymerization promotor, manufactured by Nippon Kayaku K.K.) | 2 parts |
| (8) | 2-Hydroxy-N-(2-methylphenyl)-3-naphthoamide | 15 parts |
| (9) | Methyl lactate | 1900 parts |

### (Silicone rubber layer composition)

| | |
|---|---|
| Dimethylpolysiloxane having hydroxyl groups at both ends (molecular weight 82,000) | 100 parts |
| Triacetoxyvinylsilane | 5 parts |
| 1-Trimethoxysilylpropyl-3,5-diallylisocyanurate | 2.5 parts |
| Dibutyltin laurate | 0.8 part |
| Isopar E (manufactured by Esso Chemical) | 900 parts |

### (Developer - 5)

| | |
|---|---|
| Benzyl alcohol | 2 parts |
| Pellex NBL (35 % aqueous anionic surfactant, manufactured by Kao-Atlas) | 17 parts |
| Diethanolamine | 2 parts |
| Tripropylene glycol monomethyl ether Isopar H (isoparaffinic solvent, manufactured | 45 parts |
| by Esso Chemical K.K.) | 6 parts |
| Water | 25 parts |

The dots were well reproduced similar to those in Example - 1 to give a printing plate with a light-sensitive layer in which the image line portion was color formed in blue at the unexposed portion.

### Example - 7

A litho printing plate material requiring no dampening water was obtained in a similar manner to Example - 1 except for changing the light-sensitive composition of Example - 2 as follows.

### (Photosensitive composition - 3):

| | | |
|---|---|---|
| (1) | 2,5-Diethoxy-4-morpholinobenzenediazoniumfluoroborate | 15 parts |
| (2) | Copolymer resin - 2 of 2-hydroxyethyl methacrylate, N-(4-hydroxyphenyl)methacryl amide, methyl methacrylate, acrylonitrile, allyl methacrylate with a molar ratio of 20/10/50/10/10 | 50 parts |
| (3) | Pentaerythritol triacrylate | 15 parts |
| (4) | Tetramethylolmethane tetraacrylate | 20 parts |
| (5) | Victoria Pure Blue BOH (dye, manufactured by Hodogaya Kagaku K.K.) | 1 part |
| (6) | Kayacure DETX (2,4-Diethylthioxanthone photopolymerization initiator, manufactured by Nippon Kayaku K.K.) | 5 parts |
| (7) | Kayacure EPA (p-Dimethylamino benzoic acid ethyl ester photopolymerization promotor, manufactured by Nippon Kayaku K.K.) | 2 parts |
| (8) | 2-Hydroxy-N-(2-methylphenyl)-3-naphthoamide | 15 parts |
| (9) | Methyl lactate | 1900 parts |

The dots were well reproduced similar to those in Example - 1 to give a printing plate with a light-sensitive layer in which the image line portion was color formed in blue at the unexposed portion.

### Example - 8

A litho printing plate requiring no dampening water was obtained in the same manner as in Example - 5 except for changing (4) in the light-sensitive composition of Example - 1 to that shown below.

| | | |
|---|---|---|
| (4) | N-(2-hydroxyethyl)-3,5-dihydroxybenzamide | 15 parts |

When exposed and developed in a similar manner to Example 1, dots were well reproduced to give a printing plate with a light-sensitive layer in which the image line portion was color formed in red at the unexposed portion

### Example - 9

After exposure of the litho printing plate material requiring no dampening water obtained in Example 5, developing was carried out with the developer - 6 shown below, in a similar manner to Example - 5. Subsequently, the plate material was dipped in the processing solution - 1 shown below for one minute. The dots were well reproduced similar to those in Example - 5 to give a printing plate in which the image line portion was color formed in blue at the unexposed portion.

### (Developer - 6)

| | |
|---|---|
| Benzyl alcohol | 2 parts |
| Pellex NBL | 6 parts |
| Propylene glycol | 22 parts |
| Water | 70 parts |

### (Processing solution - 1)

| | |
|---|---|
| Monoethanolamine | 3 parts |
| Water | 97 parts |

The image line portion at this time was not color formed during developing, and was color formed for the first time when processed with the processing solution - 1.

The present invention, by the use of at least one of the color forming substances and couplers in the light-sensitive layer, and effecting color formation through the component in the processing solution, can exhibit the excellent effects of sharp images after developing and no contamination of hands and clothing with the dyeing solution after developing, or contamination of an automatic developing machine.

## Claims

1. A method for preparing a printing plate, which method comprises exposing a positive working light-sensitive litho printing plate comprising a support, a light-sensitive layer and a silicone rubber layer provided thereon,
wherein the light sensitive layer comprises at least one of a diazo resin or a diazo compound, developing the exposed printing plate to form a colour during developing or after developing.

2. A method according to claim 1, wherein the diazo resin is a condensate of p-diazodiphenylamine and formaldehyde.

3. A method according to claim 2, wherein the condensate is represented by the following formula III: 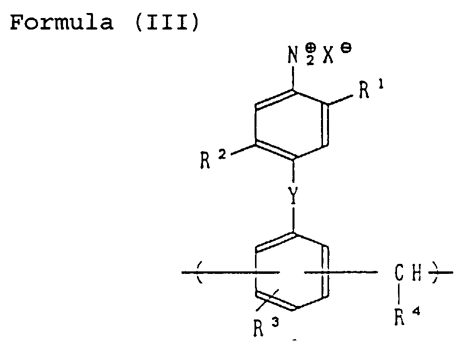 wherein R¹ and R³ each independently represent a hydrogen atom, an alkyl group or an alkoxy group, R⁴ represents a hydrogen atom, an alkyl group or a phenyl group, X represents an anion, and Y represents -NH-, -S- or -O-.

4. A method according to claim 1, wherein the diazo compound is chosen from:

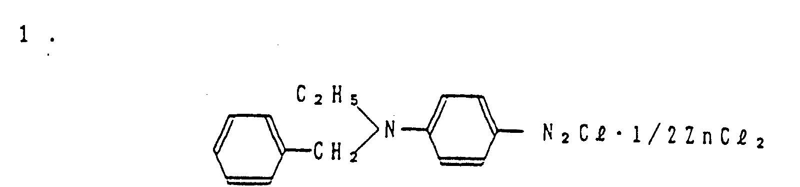

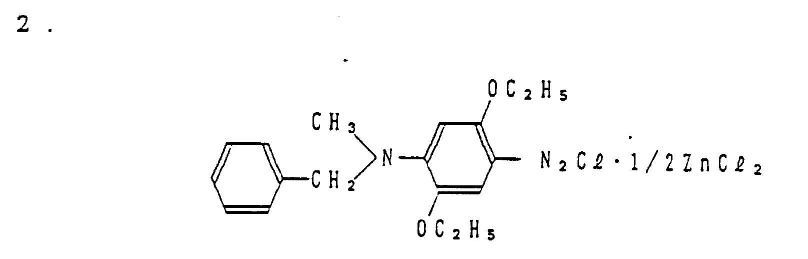

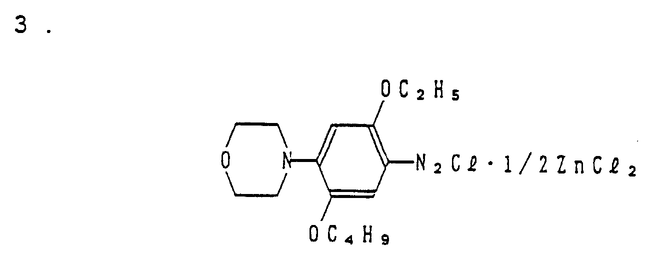

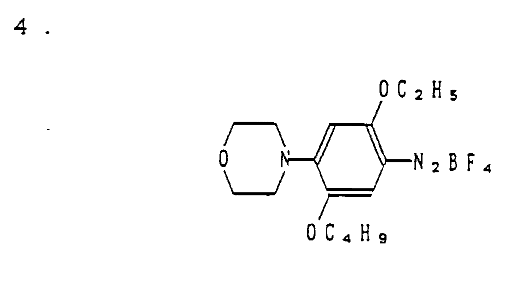

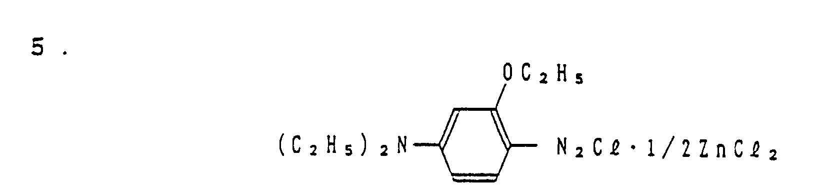

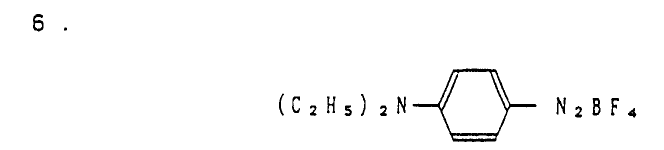

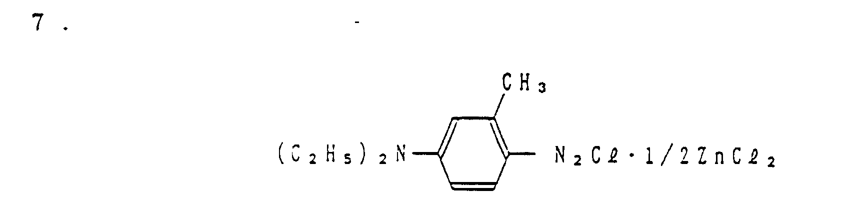

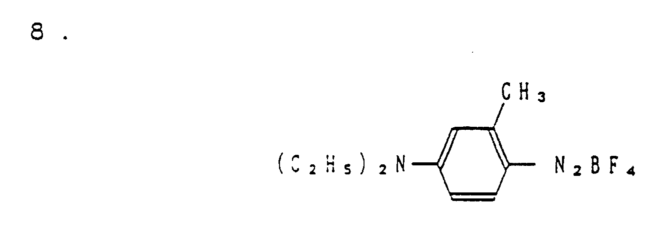

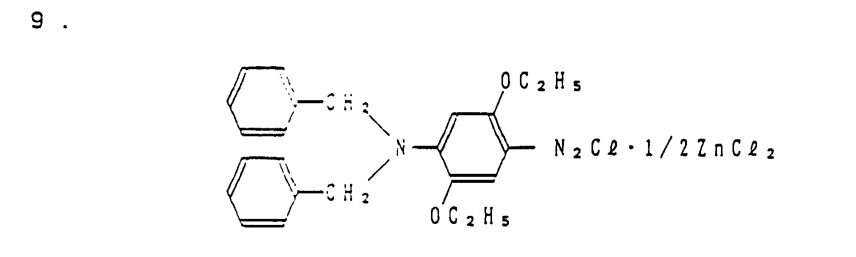

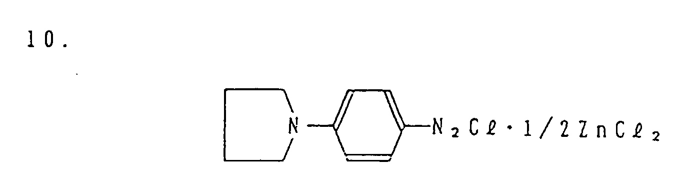

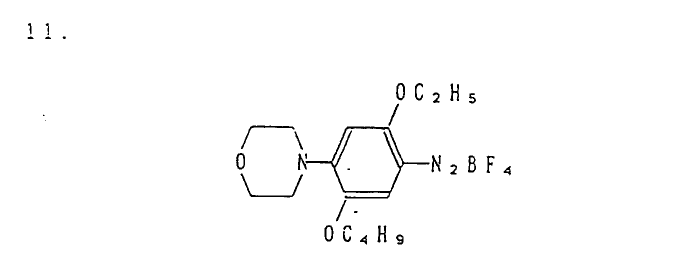

5. A method according to any preceding claim, wherein the light sensitive layer comprises a photopolymerizable compound.

6. A method according to any preceding claim, wherein the developing is carried out by a processing solution.

7. A method acording to any preceding claim, wherein the silicone rubber layer comprises a linear organic polysiloxane represented by following formula (I): 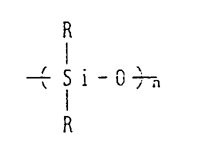 wherein n is 2 or more, R is an alkyl group having 1 to 10 carbon atoms, a halogenated alkyl group, an alkoxyl group, a vinyl group, an aryl group or a silanol group (OH group).

8. A method according to any preceding claim wherein the silicone rubber is obtainable by condensing the polysiloxane and a silane compound represented by the formula RₙSiX₄₋ₙ wherein n is from 1 to 3, the R groups may be the same or different and are each chosen from a monovalent group such as an alkyl, aryl, alkenyl or the combination of these, and these groups have at least one functional group such as halogen, amine, hydroxyl, alkoxy, aryloxy and thiol, X represents -OH, -OR², -PAc, 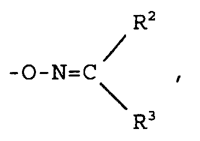 -Cl, -Br and -I wherein R² and R³ may be the same or different and are defined as for R above, and Ac represents an acetyl group.

9. A method according to any preceding claim wherein at least one of the developer, the processing solution or the light-sensitive layer comprises a coupler chosen from:

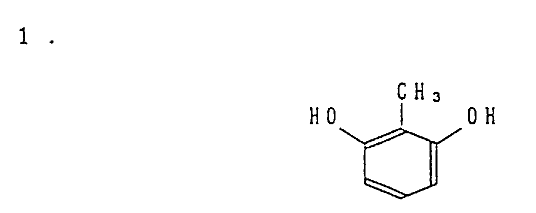

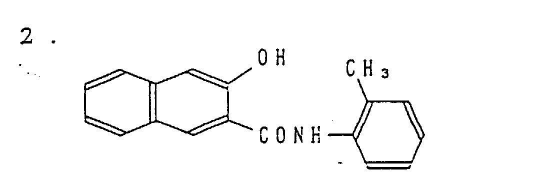

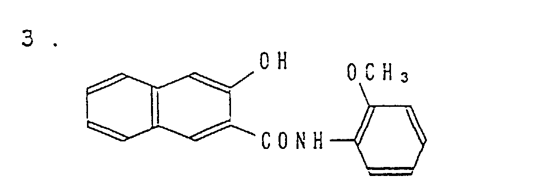

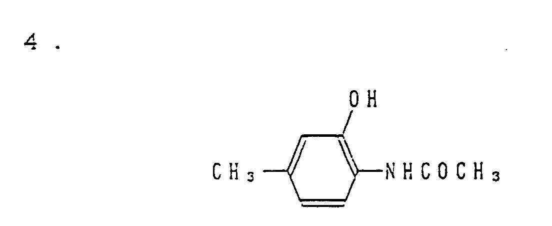

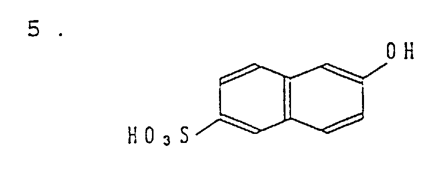

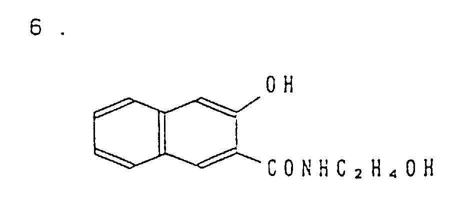

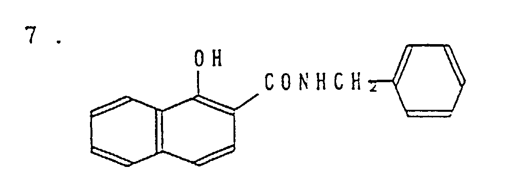

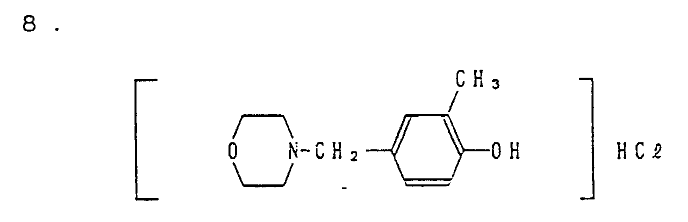

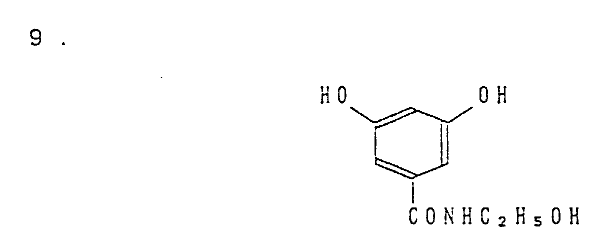

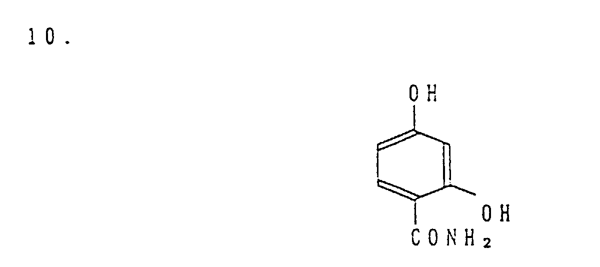

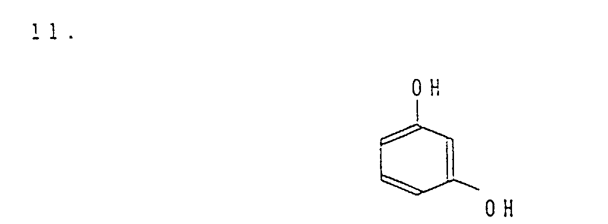

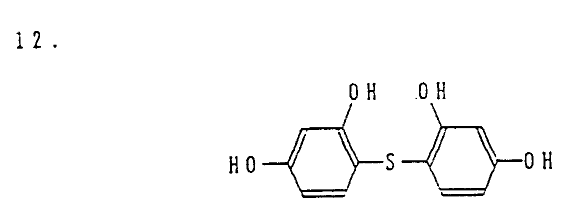

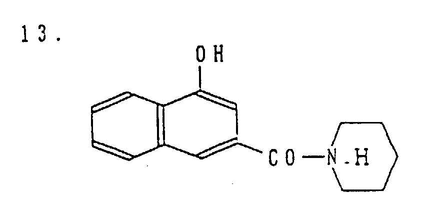

## Patentansprüche

1. Verfahren zur Herstellung einer Druckplatte durch Belichten einer positiv arbeitenden lichtempfindlichen Lithodruckplatte, umfassend einen Schichtträger und - darauf befindlich - eine mindestens ein(e) Diazoharz oder Diazoverbindung enthaltende lichtempfindliche Schicht und eine Siliconkautschukschicht und Entwickeln der belichteten Druckplatte zur Bildung einer Farbe während oder nach der Entwicklung.

2. Verfahren nach Anspruch 1, wobei es sich bei dem Diazoharz um ein Kondensat von p-Diazodiphenylamin und Formaldehyd handelt.

3. Verfahren nach Anspruch 2, wobei das Kondensat der folgenden Formel III: 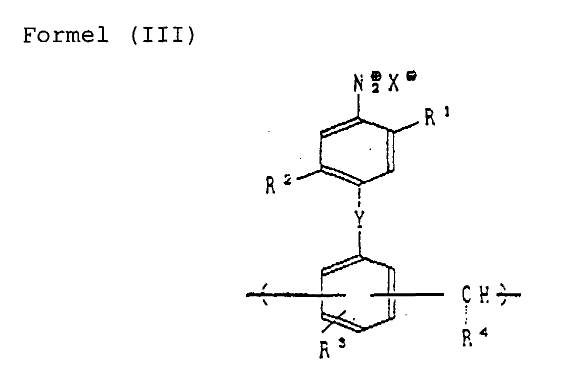 worin bedeuten:
R¹ und R³ jeweils unabhängig voneinander ein Wasserstoffatom, eine Alkylgruppe oder eine Alkoxygruppe;
R⁴ ein Wasserstoffatom, eine Alkylgruppe oder eine Phenylgruppe;
X ein Anion und
Y -NH-, -S- oder -O-
entspricht.

4. Verfahren nach Anspruch 1, wobei die Diazoverbindung aus: 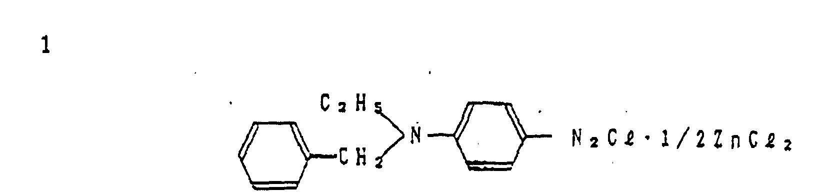 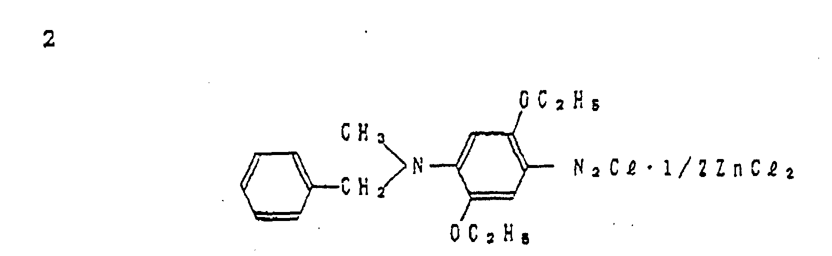 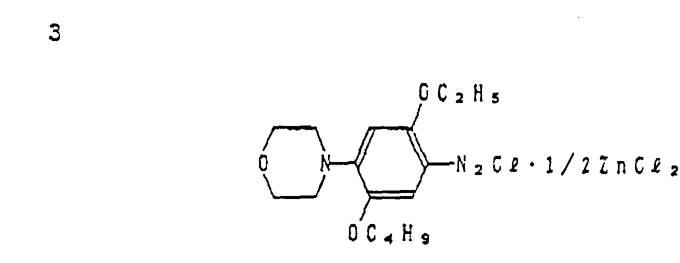 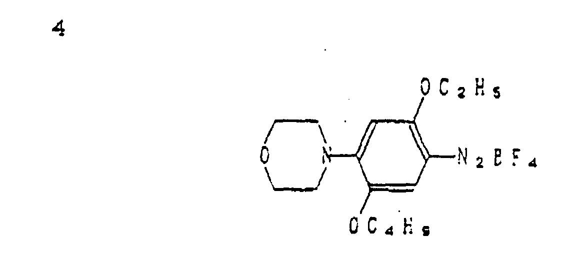 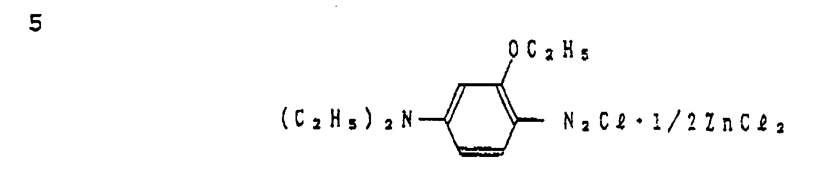 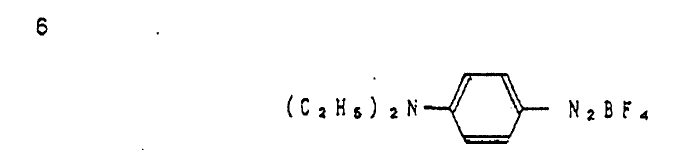 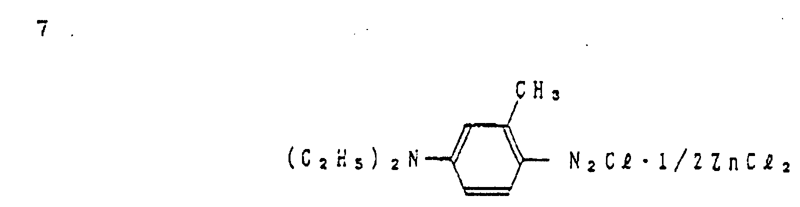 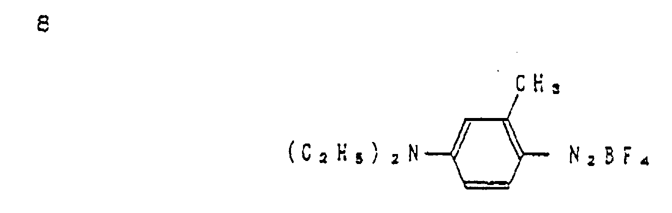 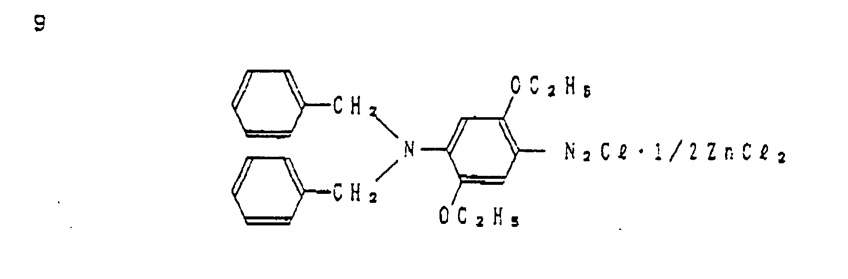 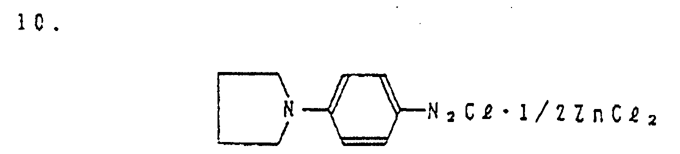 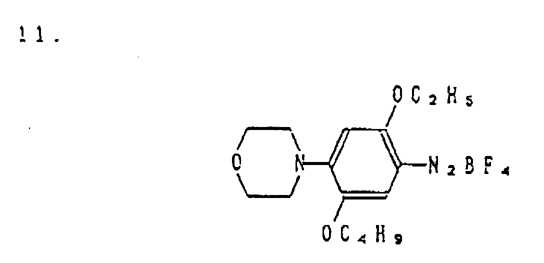 ausgewählt ist.

5. Verfahren nach einem der vorhergehenden Ansprüche, wobei die lichtempfindliche Schicht eine photopolymerisierbare Verbindung enthält.

6. Verfahren nach einem der vorhergehenden Ansprüche, wobei die Entwicklung mittels eines Behandlungsbades erfolgt.

7. Verfahren nach einem der vorhergehenden Ansprüche, wobei die Siliconkautschukschicht ein lineares organisches Polysiloxan der folgenden Formel (I): 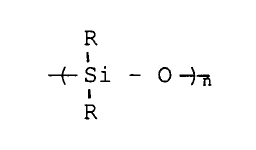 worin n = 2 oder mehr und R eine Alkylgruppe mit 1 bis 10 Kohlenstoffatom(en), eine halogenierte Alkylgruppe, eine Alkoxylgruppe, eine Vinylgruppe, eine Arylgruppe oder eine Silanolgruppe (OH-Gruppe) darstellt,
umfaßt.

8. Verfahren nach einem der vorhergehenden Ansprüche, wobei der Siliconkautschuk durch Kondensieren des Polysiloxans mit einer Silanverbindung der Formel
RₙSiX₄₋ₙ
worin bedeuten:
n = 1 bis 3;
die Gruppen R, die gleich oder verschieden sein können, jeweils eine einwertige Gruppe, z.B. eine Alkyl-, Aryl- oder Alkenylgruppe oder eine Kombination derselben, wobei diese Gruppe mindestens eine funktionelle Gruppe, z.B. Halogen, Amin, Hydroxyl, Alkoxy, Aryloxy und Thiol, aufweisen und X -OH, -OR², -Pac, 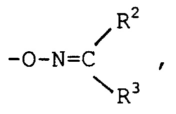 -Cl, -Br und -I mit R² und R³, die gleich oder verschieden sein können, gleich der oben angegebenen Definition von R und Ac gleich einer Acetylgruppe,
erhältlich ist.

9. Verfahren nach einem der vorhergehenden Ansprüche, wobei der Entwickler und/oder das Behandlungsbad und/oder die lichtempfindliche Schicht einen Kuppler, ausgewählt aus: 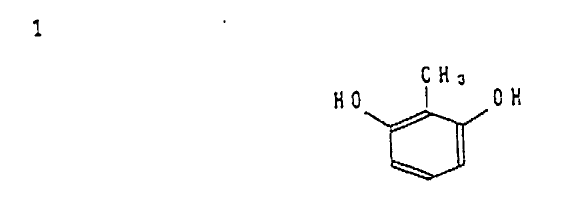 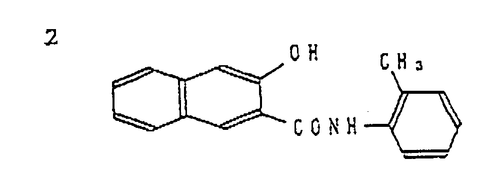 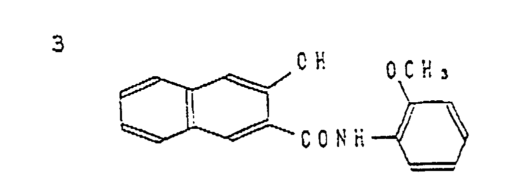 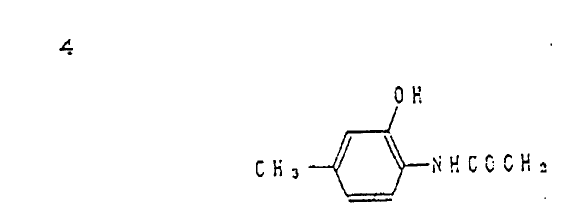 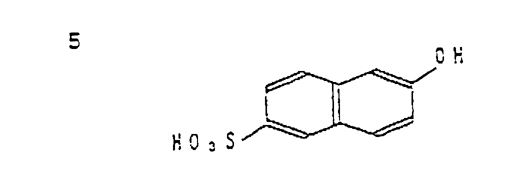 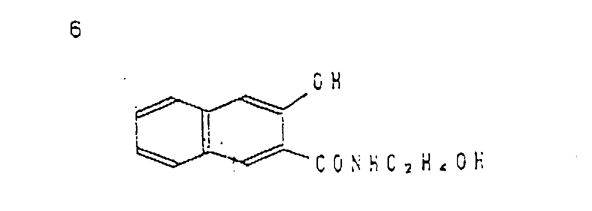 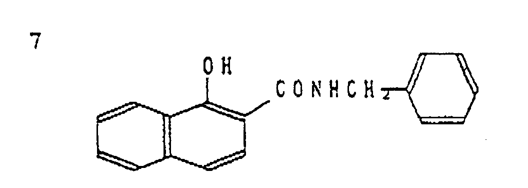 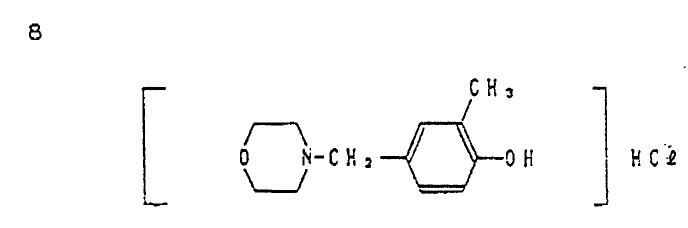 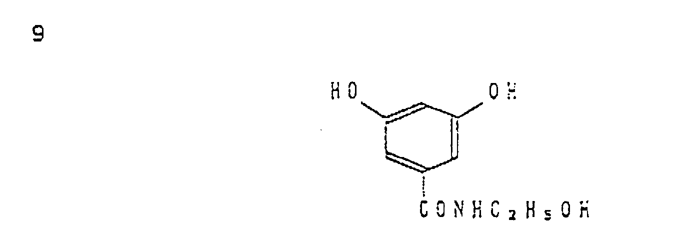 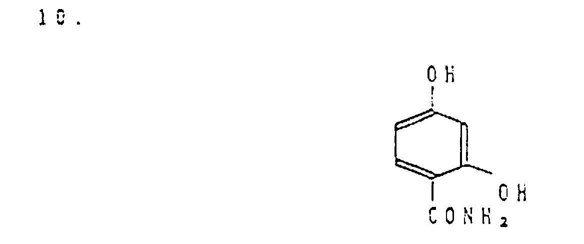 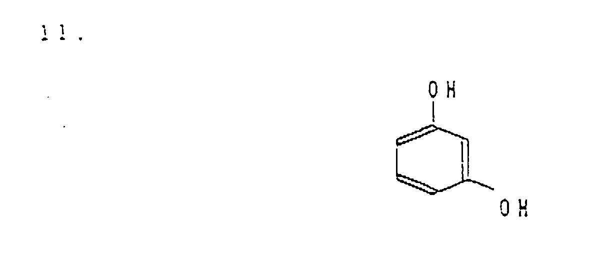 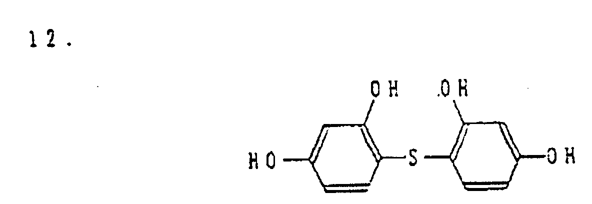 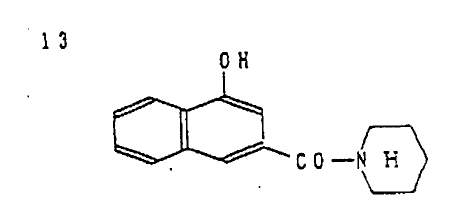 enthält.

## Revendications

1. Procédé pour préparer une plaque d'impression, ce procédé étant caractérisé par l'exposition d'une plaque d'impression lithographique photosensible positive, comprenant un support, une couche photosensible et une couche de caoutchouc de silicone présente sur celle-ci,
la couche photosensible comprenant au moins une résine diazoïque ou un composé diazoïque, et par le développement de la plaque d'impression exposée pour former une couleur pendant ou après le développement.

2. Procédé selon la revendication 1, dans lequel la résine diazoïque est un condensat de p-diazodiphénylamine et de formaldéhyde.

3. Procédé selon la revendication 2, dans lequel le condensat est représenté par la formule III suivante : 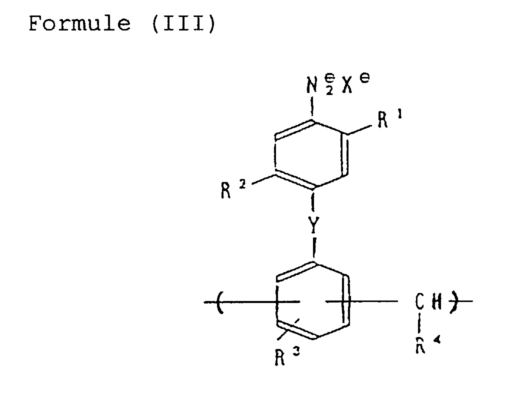 dans laquelle R¹ et R³ représentent, chacun indépendamment, un atome d'hydrogène, un groupe alkyle ou un groupe alcoxy, R⁴ représente un atome d'hydrogène, un groupe alkyle ou un groupe phényle, X représente un anion et Y représente -NH-, -S- ou -O-.

4. Procédé selon la revendication 1, dans lequel le composé diazoïque est choisi parmi :

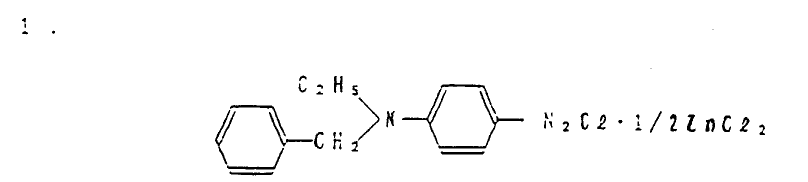

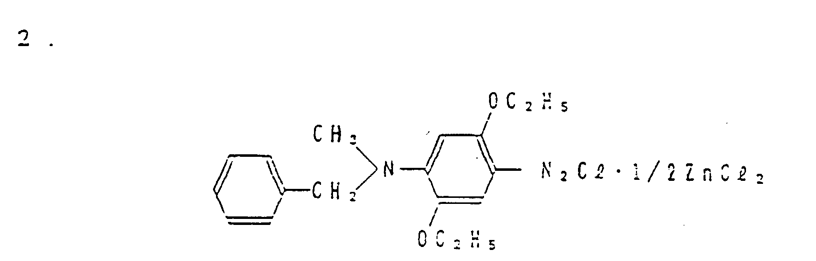

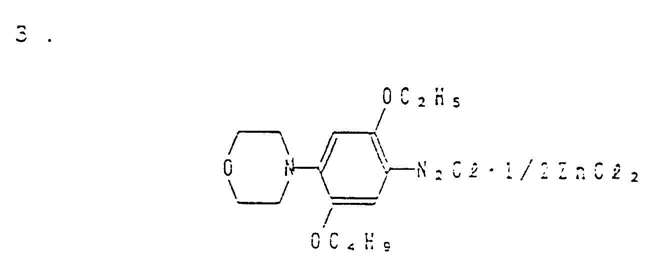

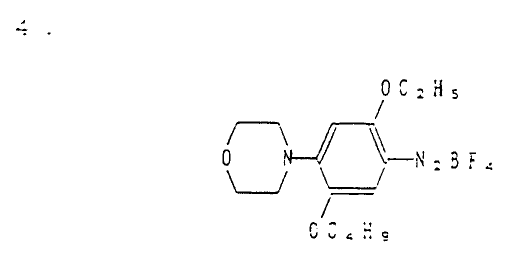

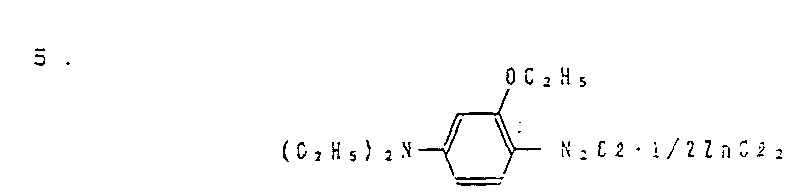

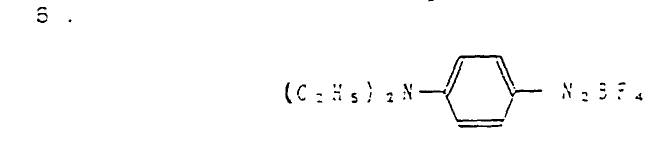

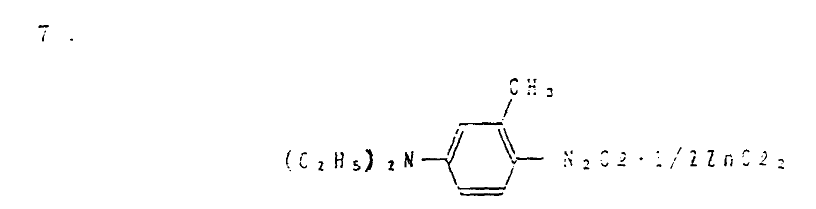

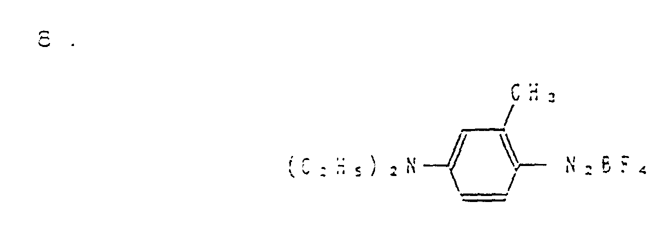

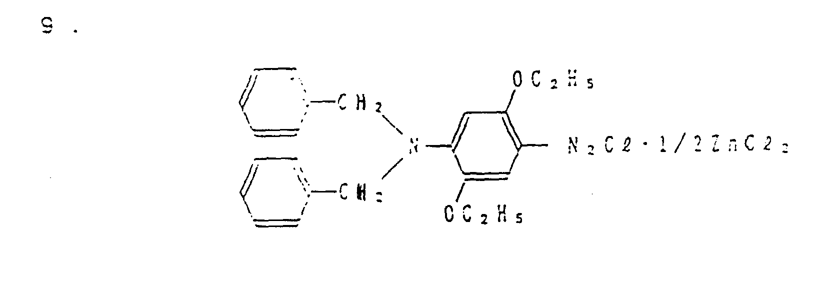

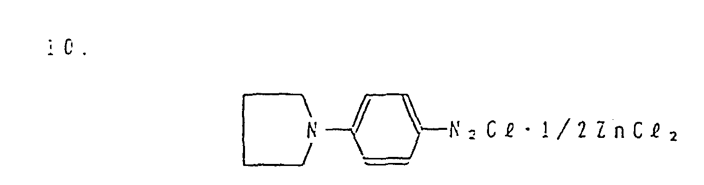

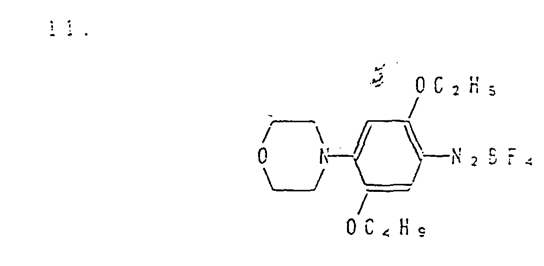

5. Procédé selon l'une quelconque des revendications précédentes, dans lequel la couche photosensible comprend un composé photopolymérisable.

6. Procédé selon l'une quelconque des revendications précédentes, dans lequel le développement est effectué à l'aide d'une solution de traitement.

7. Procédé selon l'une quelconque des revendications précédentes, dans lequel la couche de caoutchouc de silicone comprend un polysiloxane organique linéaire représenté par la formule (I) suivante : 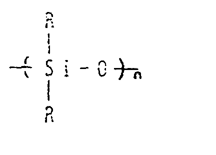 dans laquelle n est 2 ou plus, R est un groupe alkyle ayant 1 à 10 atomes de carbone, un groupe alkyle halogéné, un groupe alcoxyle, un groupe vinyle, un groupe aryle ou un groupe silanol (groupe OH).

8. Procédé selon l'une quelconque des revendications groupes R, pouvant être identiques ou différents, sont chacun choisis parmi un groupe monovalent tel qu'un groupe alkyle, aryle, alcényle ou une combinaison de ceux-ci, et ces groupes ont au moins un groupe fonctionnel tel qu'un halogène, une amine, un hydroxyle, un alcoxy, un aryloxy et un thiol, X représente -OH, -OR², -PAc, 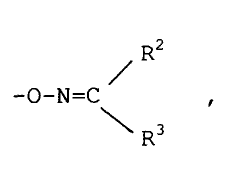 -Cl, -Br et -I
où R² et R³ qui peuvent être identiques ou différents sont tels que définis ci-dessus pour R, et Ac représente un groupe acétyle.

9. Procédé selon l'une quelconque des revendications précédentes, dans lequel au moins l'un choisi parmi le développateur, la solution de traitement et la couche photosensible comprend un agent de couplage choisi parmi :
